(19) Europäisches Patentamt
European Patent Office
Office européen des brevets

(11) EP 1 186 051 B1

(12) FASCICULE DE BREVET EUROPEEN

(45) Date de publication et mention
de la délivrance du brevet:
**20.02.2013 Bulletin 2013/08**

(21) Numéro de dépôt: **00938886.9**

(22) Date de dépôt: **05.06.2000**

(51) Int Cl.:
*H01L 29/10* ^(2006.01)    *H01L 29/78* ^(2006.01)
*H01L 21/336* ^(2006.01)   *H01L 21/265* ^(2006.01)
*H01L 21/225* ^(2006.01)

(86) Numéro de dépôt international:
**PCT/FR2000/001537**

(87) Numéro de publication internationale:
**WO 2000/077856 (21.12.2000 Gazette 2000/51)**

(54) **DISPOSITIF SEMI-CONDUCTEUR A TENSION DE SEUIL COMPENSEE ET PROCEDE DE FABRICATION**

HALBEITERBAUELEMENT MIT AUSGEGLICHENER SCHWELLENSPANNUNG UND VERFAHREN ZU DESSEN HERSTELLUNG

SEMICONDUCTOR DEVICE WITH COMPENSATED THRESHOLD VOLTAGE AND METHOD FOR MAKING SAME

(84) Etats contractants désignés:
**GB IT**

(30) Priorité: **11.06.1999 FR 9907391**

(43) Date de publication de la demande:
**13.03.2002 Bulletin 2002/11**

(73) Titulaire: **Fahrenheit Thermoscope LLC
Las Vegas, NV 89119 (US)**

(72) Inventeurs:
• **SKOTNICKI, Thomas
F-38920 Crolles Montfort (FR)**
• **GWOZIECKI, Romain
F-38000 Grenoble (FR)**

(74) Mandataire: **Small, Gary James et al
Carpmaels & Ransford
One Southampton Row
London
WC1B 5HA (GB)**

(56) Documents cités:
**EP-A- 0 763 855     US-A- 5 371 394**

• **KURATA H ET AL: "SELF-ALIGNED CONTROL OF THRESHOLD VOLTAGES IN SUB-0.2-MUM MOSFET'S" IEEE TRANSACTIONS ON ELECTRON DEVICES,US,IEEE INC. NEW YORK, vol. 45, no. 10, 1 octobre 1998 (1998-10-01), pages 2161-2166, XP000786856 ISSN: 0018-9383 cité dans la demande**
• **YOSHINORI OKUMURA ET AL: "SOURCE-TO-DRAIN NONUNIFORMLY DOPED CHANNEL (NUDC) MOSFET STRUCTURES FOR HIGH CURRENT DRIVABILITY AND THRESHOLD VOLTAGE CONTROLLABILITY" IEEE TRANSACTIONS ON ELECTRON DEVICES,US, IEEE INC. NEW YORK, vol. 39, no. 11, 1 novembre 1992 (1992-11-01), pages 2541-2552, XP000321695 ISSN: 0018-9383**
• **PATENT ABSTRACTS OF JAPAN vol. 1995, no. 02, 31 mars 1995 (1995-03-31) -& JP 06 318698 A (MITSUBISHI ELECTRIC CORP), 15 novembre 1994 (1994-11-15)**

**Description**

La présente invention concerne d'une manière générale un dispositif semi-conducteur, tel qu'un transistor MOS, présentant une compensation de la chute de la tension de seuil ($V_{th}$) due aux effets canaux courts ainsi qu'un procédé de fabrication d'un tel dispositif semi-conducteur.

Les documents JP 06318698; US-A-5371394 et EP-A-0 763 855 décrivent des exemples de dispositifs semi-conducteurs.

Pour une longueur nominale (L) donnée de canal d'un transistor, la tension de seuil ($V_{th}$) en particulier pour les transistors à canaux courts, c'est-à-dire ayant une longueur de canal inférieure à 0,25$\mu$m et typiquement une longueur de canal L de l'ordre de 0,18$\mu$m, la tension de seuil présente une chute brutale.

La tension de seuil d'un dispositif semi-conducteur tel qu'un transistor MOS, en particulier d'un dispositif à canal court, est un paramètre critique du dispositif. En effet, le courant de fuite du dispositif, par exemple du transistor, dépend fortement de cette tension de seuil. Compte-tenu des tensions d'alimentation actuelles et envisagées dans le futur (de 0,9 volt à 1,8 volt) pour de tels dispositifs et des courants de fuite admis ($I_{off}$ d'environ 1NA/$\mu$m), la tension de seuil $V_{th}$ doit présenter des valeurs d'environ 0,2 à 0,25 volt.

La chute de tension brutale (roll-off) dans les zones de la région de canal du dispositif semi-conducteur conduisent à une dispersion des caractéristiques électriques du dispositif et rendent difficile l'obtention des tensions de seuil voulues.

Afin de remédier à cette chute de la tension de seuil dans les dispositifs semi-conducteurs tels que des transistors MOS, on a proposé, comme décrit dans l'article "Self-Aligned Control of Threshold Voltages in Sub-0.2-$\mu$m MOSFET's" (Réglage auto-aligné des tensions de seuil dans les MOSFET sub-0,2$\mu$m) Hajima Kurata et Toshihiro Sugii, IEEE Transactions on Electron Devices, Vol. 45, No. 10, Octobre 1998, de former dans la région de canal des poches adjacentes aux jonctions des régions de source et de drain ayant une conductivité de même type que le substrat mais dont la concentration en dopant est supérieure à celle du substrat.

Bien que cette solution réduise le gradient de chute de la tension de seuil dans la région de canal, les effets canaux courts conduisent à une chute de la tension de seuil $V_{th}$ plus rapide que l'augmentation de la tension de seuil que l'on peut obtenir en incorporant les poches de compensation de l'art antérieur.

Par conséquent, si on peut avec ces poches de compensation de l'art antérieur partiellement compenser localement la chute de la tension de seuil $V_{th}$, il n'est pas possible ainsi d'obtenir une compensation complète de la chute sur la totalité du domaine voulu de la région de canal.

La présente invention a donc pour objet un dispositif semi-conducteur, tel qu'un transistor MOS, qui remédie aux inconvénients des dispositifs de l'art antérieur.

La présente invention a plus particulièrement pour objet un dispositif semi-conducteur, tel qu'un transistor MOS, dont la chute de tension de seuil $V_{th}$ due aux effets canaux courts est compensée pratiquement et permettant d'atteindre des longueurs de canal arbitrairement petites mais non nulles.

La présente invention a également pour objet un dispositif semi-conducteur, tel qu'un transistor MOS, présentant une tension de seuil $V_{th}$ constante lorsque la longueur de canal L diminue jusqu'à des longueurs effectives de canal très faibles, par exemple de 0,025$\mu$m ou moins.

La présente invention a également pour objet un procédé pour réaliser un dispositif semi-conducteur tel que défini précédemment. Ce procédé peut s'appliquer à des dispositifs à canaux de longueur arbitrairement petite, par ailleurs technologiquement réalisables.

On atteint les buts ci-dessus selon l'invention, en réalisant un dispositif semi-conducteur, comprenant un substrat semi-conducteur ayant une concentration Ns prédéterminée en un dopant d'un premier type de conductivité, des régions de source et de drain dopées avec un dopant d'un second type de conductivité opposé au premier et définissant dans le substrat des jonctions délimitant une région de canal de longueur nominale LN prédéterminée, et une première poche adjacente dans la région de canal à chacune des jonctions et ayant une longueur Lp prédéterminée, lesdites premières poches étant dopées avec un dopant du premier type de conductivité de concentration Np augmentant localement la concentration nette du substrat au-delà de $N_s$, ce dispositif comprenant dans la région de canal, au moins une seconde poche adjacente à chacune des jonctions et superposée à chacune des premières poches, ces secondes poches ayant une longueur Ln telle que Ln > Lp et étant dopées avec un dopant du second type de conductivité à une concentration Nn telle que Nn <Np et diminuant localement la concentration nette du dopant du premier type de conductivité dans le substrat et en ce que la concentration $N_n$ en dopant du second type de connectivité des secondes poches satisfait à la relation $N_n < N_s$.

Dans une réalisation préférée de l'invention, les secondes poches comprennent une pluralité de poches élémentaires superposées les unes aux autres, chaque poche élémentaire d'un rang i donné ayant une longueur prédéterminée $Ln_i$ et une concentration prédéterminée en dopant du second type de conductivité $Nn_i$ satisfaisant les relations suivantes :

$$Ln_1 > Lp$$

$$Ln_{i-1} < Ln_i < Ln_{i+1},$$

$$Nn_{i-1} > Nn_i > Nn_{i+1},$$

et

la somme $\Sigma Nn_i$ des concentrations en dopant du second type de conductivité des poches élémentaires étant telle que :

$$\Sigma Nni < Ns.$$

En d'autres termes, les secondes poches diminuent la concentration nette en dopant du premier type de conductivité tant dans les premières poches que dans la région de canal, mais ne changent pas le type de conductivité des premières poches ni de la région de canal.

La présente invention concerne également un procédé pour réaliser un dispositif semi-conducteur tel que défini précédemment qui comprend la formation dans un substrat semi-conducteur ayant une concentration prédéterminée Ns en un dopant d'un premier type de conductivité, d'une région de source et d'une région de drain dopées avec un dopant d'un second type de conductivité opposé au premier, les régions de source et de drain formant dans le substrat des jonctions délimitant entre elles une région de canal ayant une longueur nominale L prédéterminée, et la formation dans la région de canal dans une zone adjacente à chacune des jonctions d'une première poche ayant une longueur Lp prédéterminée et une concentration Np prédéterminée augmentant localement la concentration nette du substrat au-delà de la concentration initiale Ns, le procédé se caractérisant par le fait qu'il comprend en outre l'implantation dans la région de canal d'un dopant du second type de conductivité opposé au premier dans des conditions telles qu'il se forme dans la région de canal au moins une seconde poche superposée à chacune respectivement des premières poches et ayant une longueur Ln telle que Ln > Lp et une concentration Nn en dopant du premier type telle que Nn < Np et diminuant localement la concentration nette du substrat mais sans changer le type de conductivité.

Dans une réalisation préférée du procédé de l'invention, l'implantation du dopant du second type de conductivité consiste en une série d'implantations successives dans des conditions telles que les secondes poches formées sont chacune constituées par une pluralité de poches élémentaires superposées les unes aux autres, chaque poche élémentaire d'un rang i donné ayant une longueur $Ln_i$ et une concentration en dopant du second type de conductivité $Nn_i$ satisfaisant les relations

$$Ln_1 > Lp$$

$$Ln_{i-1} < Ln_i < Ln_{i+1},$$

$$Nn_{i-1} > Nn_i > Nn_{i+1},$$

et

la somme $\Sigma Nn_i$ des concentrations en dopant du second type de conductivité des poches élémentaires étant telle que :

$$\Sigma Nni < Ns.$$

Les longueurs des poches Lp et Ln sont établies à partir des jonctions.

L'implantation de dopant dans un substrat semi-conducteur est un procédé connu et on peut dans le présent procédé utiliser tout procédé d'implantation classiquement utilisé dans la technologie des semi-conducteurs.

Comme cela est connu, la réalisation de poches dopées dans un substrat semi-conducteur dépend de l'angle d'incidence de l'implantation par rapport à la normale au substrat, de la dose et de l'énergie d'implantation du dopant. Ainsi, en faisant varier l'angle d'incidence et la dose de dopant, on peut accroître la longueur de la poche implantée et faire varier la concentration en dopant.

En variante, pour faire varier la longueur des secondes poches implantées ainsi que leur concentration en dopant, on peut réaliser des implantations successives avec le même angle d'incidence par rapport à la normale, la même dose et la même énergie d'implantation mais en soumettant le dispositif après chaque implantation successive à un traitement de recuit thermique de manière à faire diffuser différemment le dopant implanté dans le substrat.

La suite de la description se réfère aux figures annexées qui représentent respectivement :

Figure 1, une première réalisation d'un dispositif semi-conducteur, tel qu'un transistor MOS, selon l'invention ;
Figure 2, une seconde réalisation d'un dispositif semi-conducteur selon l'invention ; et
Figure 3, un graphe de la tension de seuil ($V_{th}$) de différents dispositifs semi-conducteurs selon l'invention en fonction de la longueur effective de canal.

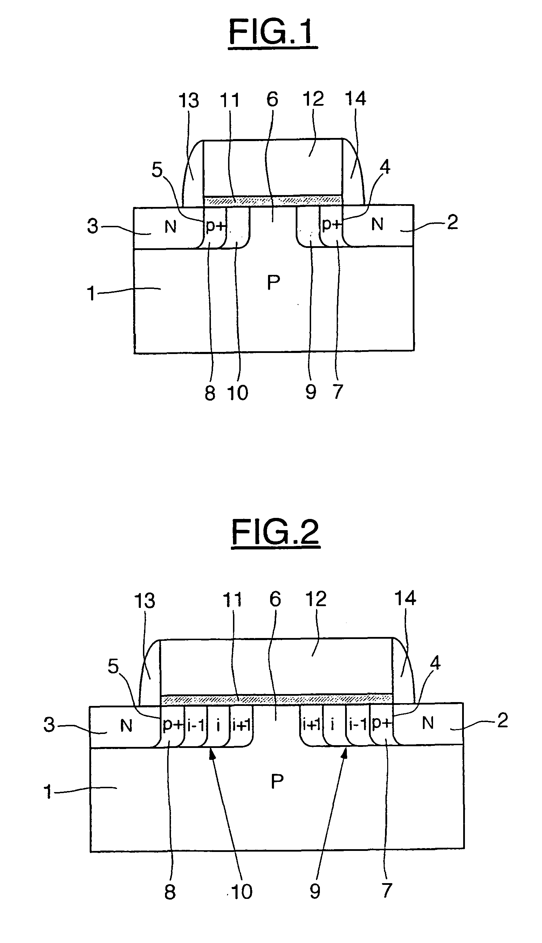

En se référant à la figure 1, on a représenté une première réalisation d'un dispositif semi-conducteur selon l'invention, tel qu'un transistor MOS qui comprend comme cela est classique un substrat semi-conducteur 1, par exemple un substrat de silicium dopé avec un dopant d'un premier type de conductivité, par exemple de conductivité P, dans lequel sont formées des régions de source 2 et de drain 3 dopées avec un dopant d'un second type de conductivité opposé au premier par exemple un dopant de type N qui définissent dans le substrat des jonctions 4, 5 délimitant entre elles une région de canal 6.

Comme cela est connu, la région de canal 6 est recouverte d'une couche d'oxyde de grille 11, par exemple une mince couche d'oxyde de silicium, elle-même-surmontée par une grille 12 par exemple en silicium. La grille 12, comme cela est également bien connu peut être flanquée sur deux côtés opposés d'espaceurs 13, 14 en matériau diélectrique approprié.

Comme cela est connu, pour réduire la vitesse de la chute de tension de seuil $V_{th}$ dans la région de canal 6, on a formé dans la région de canal, deux premières poches 7, 8, adjacentes chacune respectivement à une des jonctions 4, 5. Ces poches sont dopées au moyen d'un dopant du premier type de conductivité P mais à une concentration Np en dopant de premier type augmentant localement la concentration du substrat au-delà de Ns et, ayant une longueur Lp la plus courte possible.

Selon l'invention, on a formé dans la région de canal 6, deux secondes poches 9, 10 qui se superposent chacune à une des premières poches mais dont la longueur Ln est supérieure à la longueur Lp des premières poches et qui sont dopées avec un dopant du second type de conductivité par exemple un dopant de type N à une concentration Nn telle que Nn soit inférieure à la concentration Ns en dopant du premier type de conductivité au substrat.

Ainsi, dans les zones des secondes poches, la concentration nette en dopant du premier type de conductivité par exemple le dopant de type P, est réduite mais on ne change pas la nature de la conductivité de la région du canal qui demeure toujours une région de conductivité de type P.

En se référant la figure 2 où les mêmes numéros de référence désignent les mêmes éléments que précédemment, on a représenté une autre réalisation d'un dispositif semi-conducteur selon l'invention qui ne diffère du dispositif précédent de la figure 1 que par le fait que les secondes poches 9, 10 sont en fait constituées par des pluralités de poches élémentaires superposées les unes aux autres, trois poches élémentaires dans la réalisation représentée sur la figure 2.

Chaque poche élémentaire d'un rang donné i a une longueur $Ln_i$ et une concentration $Nn_i$ en dopant du second type de conductivité qui satisfont les relations suivantes :

$$Lp < Ln_i$$

$$Ln_{i-1} < Ln_i < Ln_{i+1},$$

$$N_{n_{i-1}} > N_{n_i} > N_{n_{i+1}},$$

et la somme $\Sigma Nn_i$ des concentrations en dopant du second type de conductivité des poches élémentaires étant telle que :

$$\Sigma Nni < Ns.$$

En d'autres termes, les poches élémentaires superposées aux premières poches 7 et 8 sont également superposées les unes aux autres mais ont des longueurs croissantes et concurremment des concentrations en dopant du premier type de conductivité qui diminuent au fur et à mesure que leurs longueurs croissent.

D'autre part, la somme des concentrations $\Sigma Nn_i$ des poches élémentaires superposées est telle qu'elle reste inférieure à la concentration Ns en dopant du premier type de conductivité du substrat de sorte qu'on ne modifie pas le type de conductivité de la région de canal 6.

Ainsi, dans le cas représenté à la figure 2, où les secondes poches sont constituées par 3 poches élémentaires, les longueurs et concentrations en dopant des poches élémentaires satisfont les relations :

$$Lp < Ln_1$$

$$Ln_1 < Ln_2 < Ln_3$$

$$Nn_1 > Nn_2 > Nn_3,$$

et

$$Nn_1 + Nn_2 + Nn_3 < Ns.$$

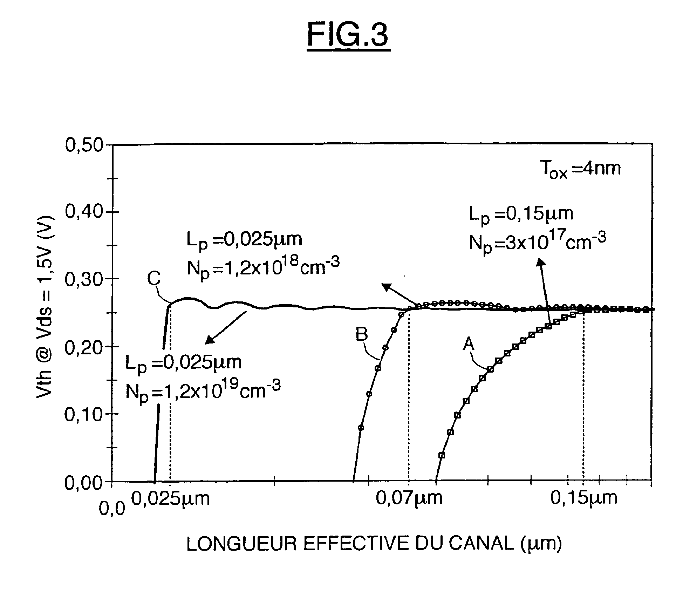

On a représenté figure 3, des graphes simulés de tension de seuil $V_{th}$ pour des transistors comportant une couche d'oxyde de grille de 4nm d'épaisseur et pour une tension drain/source de 1,5 volt en fonction de la longueur effective de canal. Les longueurs Lp et les concentrations Np des premières poches dopées avec un dopant de même type que le substrat correspondent à la longueur minimale à obtenir pour le canal et pour le dopage le plus élevé.

La courbe A correspond à la superposition d'une seule seconde poche selon l'invention et montre que l'on obtient un $V_{th}$ plat pour une longueur de canal jusqu'à $0,15\mu m$.

La courbe B correspond à la superposition de deux secondes poches selon l'invention et montre qu'on obtient un $V_{th}$ plat pour une longueur de canal jusqu'à $0,07\mu m$.

Enfin, la courbe C correspond à la superposition de sept secondes poches selon l'invention et montre que l'on peut obtenir un $V_{th}$ plat pour une longueur de canal jusqu'à 0,025µm.

Ainsi, les courbes ci-dessus montrent que les dopages nécessaires restent raisonnables et permettent d'obtenir des courbes $V_{th}$ en fonction de la longueur effective de canal jusqu'à des longueurs effectives de 25nm et ce même avec des épaisseurs d'oxyde de grille de 4nm.

## Revendications

1. Dispositif semi-conducteur comprenant un substrat semi conducteur (1) ayant une concentration Ns prédéterminée en un dopant d'un premier type de conductivité, des régions de source (2) et de drain (3) dopées avec un dopant d'un second type de conductivité opposé au premier et définissant dans le substrat des jonctions (4, 5) délimitant une région de canal (6) de longueur nominale LN prédéterminée et une première poche (7, 8) adjacente dans la région de canal (6) à chacune des jonctions (4, 5) et ayant une longueur Lp prédéterminée, lesdites premières poches (7, 8) étant dopées avec un dopant du premier type de conductivité de concentration Np augmentant localement la concentration nette du substrat au-dèlà de Ns, ce dispositif comprenant dans la région de canal (6), au moins une seconde poche (9, 10) adjacente à chacune des jonctions (4, 5) et superposée à chacune des premières poches (7, 8), lesdites secondes poches (9, 10) ayant une longueur Ln telle que Ln > Lp et étant dopées avec un dopant du second type de conductivité à une concentration Nn telle que Nn < Np et diminuant localement la concentration nette du dopant du premier type de conductivité dans le substrat et en ce que la concentration Nn en dopant du second type de conductivité des secondes poches satifsfait à la relation Nn<Ns.

2. Dispositif semi-conducteur selon la revendication 1, **caractérisé en ce que** les secondes poches (9, 10) comprennent une pluralité de poches élémentaires superposées les unes aux autres, chaque poche élémentaire d'un rang i donné ayant une longueur $Ln_i$ prédéterminée et une concentration en dopant du second type de conductivité $Nn_i$ prédéterminée satisfaisant les relations:

$$Ln_1 > Lp$$

$$Ln_{i-1} < Ln_i < Ln_{i+1},$$

$$Nn_{i-1} > Nn_i > Nn_{i+1},$$

et

la somme $\Sigma Nn_i$ des concentrations en dopant du second type de conductivité des poches élémentaires de la pluralité satisfaisant la relation $\Sigma Nn_i < Ns$.

3. Dispositif selon la revendication 1 ou 2, **caractérisé en ce que** le dispositif est un transistor MOS.

4. Procédé pour réaliser un dispositif semi-conducteur selon la revendication 1 ou 2 comprenant:

   - la formation dans un substrat semi-conducteur (1) ayant une concentration Ns prédéterminée en un dopant du premier type de conductivité, d'une région de source (2) et d'une région de drain (3) dopées avec un dopant d'un second type de conductivité opposé au premier, lesdites régions de source et de drain formant dans le substrat des jonctions (4, 5) délimitant entre elles une région de canal (6) ayant une longueur nominale L prédéterminée, et

   - la formation dans la région de canal (6) dans une zone adjacente à chacune des jonctions (4, 5) d'une première poche (7, 8) ayant une longueur Lp prédéterminée et une concentration Np prédéterminée en dopant du premier type de conductivité augmentant localement la concentration nette du substrat au-delà de Ns, **caractérisé en ce qu'**il comprend en outre

   - l'implantation dans la région de canal (6) d'un dopant du second type de conductivité opposé au premier dans des conditions telles qu'il se forme dans la région du canal (6) au moins une seconde poche (9, 10) superposée à chacune respectivement des premières poches (7, 8), cette seconde poche ayant une longueur Ln telle que Ln > Lp et une concentration Nn en dopant du premier type telle que Nn < Np et diminuant localement la concentration nette du dopant du premier type de conductivité dans le substrat et **en ce que** la concentration Nn en dopant du second type de conductivité des secondes poches satifsfait à la relation Nn<Ns.

5. Procédé selon la revendication 4, **caractérisé en ce que** l'implantation du dopant du second type de conductivité consiste en une série d'implantations successives telle que les secondes poches (9, 10) sont chacune constituée par une pluralité de poches élémentaires superposées, chaque poche élémentaire d'un rang i donné ayant une longueur $Ln_i$ et une concentration $Nn_i$ en dopant du second type de conductivité satisfaisant les relations:

$$Ln_1 < Lp$$

$$Ln_{i-1} < Ln_i < Ln_{i+1},$$

$$Nn_{i-1} > Nn_i > Nn_{i+1},$$

et

la somme $\Sigma Nn_i$ des concentrations en dopant du second type de conductivité de la pluralité de poches élémentaires satisfaisant la relation $\Sigma Nn_i < Ns$.

6. Procédé selon la revendication 4 ou 5, **caractérisé en ce que** les conditions d'implantation comprennent l'angle d'incidence d'implantation par rapport à la normale au substrat, la dose et l'énergie d'implantation.

7. Procédé selon la revendication 5, **caractérisé en ce que** dans la série d'implantations successives, on fait croître l'angle d'incidence par rapport à la normale et on diminue la dose d'implantation d'une implantation successive à l'autre.

8. Procédé selon la revendication 5, **caractérisé en ce que** la série d'implantations successives, consiste à implanter le dopant du second type de conductivité en utilisant le même angle d'incidence par rapport à la normale au substrat, la même dose et la même énergie d'implantation et à soumettre entre chaque implantation successive le dispositif à un traitement de recuit différent.

**Claims**

1. Semiconductor device comprising a semiconductor substrate (1) having a preset concentration Ns of a first conductivity type dopant, a source region (2) and a drain region (3) both of which regions are doped with a dopant of a second conductivity type opposite to the first and defining in the substrate junctions (4, 5) bounding a channel region (6) of preset nominal length LN, and a first well (7, 8) adjacent, in the channel region (6), to each of the junctions (4, 5) and having a preset length Lp, said first wells (7, 8) being doped with a dopant of the first conductivity type with a concentration Np that locally increases the net concentration of the substrate above Ns, this device comprising, in the channel region (6), at least one second well (9, 10) adjacent each of the junctions (4, 5) and superposed on each of the first wells (7, 8), said second wells (9, 10) having a length Ln such that Ln > Lp and being doped with a dopant of the second conductivity type to a concentration Nn such that Nn < Np and locally decreasing, in the substrate, the net concentration of the dopant of the first conductivity type, and in that the concentration Nn of the second conductivity type dopant in the second wells satisfies the relation Nn < Ns.

2. Semiconductor device according to Claim 1, **characterized in that** the second wells (9, 10) comprise a plurality of elementary wells superposed on one another, each elementary well of a given row i having a preset length $Ln_i$ and a preset concentration $Nn_i$ of the second conductivity type dopant satisfying the relationships:

$$Ln_1 > Lp;$$

$$Ln_{i-1} < Ln_i < Ln_{i+1};$$

and

$$Nn_{i-1} > Nn_i > Nn_{i+1},$$

and the sum $\Sigma Nn_i$ of the concentrations of the second conductivity type dopant in the elementary wells of the plurality satisfying the relationship $\Sigma Nn_i < Ns$.

3. Device according to either of Claims 1 and 2, **characterized in that** the device is a MOS transistor.

4. Process for producing a semiconductor device according to either of Claims 1 and 2, comprising:

   - forming, in a semiconductor substrate (1) having a preset concentration Ns of a first conductivity type dopant, a source region (2) and a drain region (3) both of which regions are doped with a dopant of a second conductivity type opposite to the first, said source and drain regions forming, in the substrate, junctions (4, 5) bounding between them a channel region (6) having a preset nominal length L; and
   - forming in the channel region (6) in a zone adjacent each of the junctions (4, 5) a first well (7, 8) having a preset length Lp and a preset concentration Np of the first conductivity type dopant locally increasing the net concentration of the substrate above Ns, **characterized in that** it furthermore comprises
   - implanting, in the channel region (6), a dopant of the second conductivity type opposite the first, under conditions such that at least one second well (9, 10) is formed in the channel region (6), this second well being superposed on each of the first wells (7, 8), respectively, and having a length Ln such that Ln > Lp and a concentration Nn of the first dopant type such that Nn < Np and locally decreasing, in the substrate, the net concentration of the dopant of the first conductivity type, and **in that** the concentration Nn of the second conductivity type dopant in the second wells satisfies the relationship Nn < Ns.

5. Process according to Claim 4, **characterized in that** the implantation of the dopant of the second conductivity type consists in a series of successive implantations, such that the second wells (9, 10) each consist of a plurality of superposed elementary wells, each elementary well of a given row i having a length $Ln_i$ and a concentration $Nn_i$ of the second conductivity type dopant satisfying the relationships:

$$Ln_1 > Lp;$$

$$Ln_{i-1} < Ln_i < Ln_{i+1};$$

$$Nn_{i-1} > Nn_i > Nn_{i+1},$$

and the sum $\Sigma Nn_i$ of the concentrations of the second conductivity type dopant in the plurality of elementary wells satisfying the relationship $\Sigma Nn_i < Ns$.

6. Process according to either of Claims 4 and 5, **characterized in that** the implantation conditions comprise the angle of attack of the implantation with respect to the normal to the substrate, the dose, and the implantation energy.

7. Process according to Claim 5, **characterized in that**, in the series of successive implantations, the angle of attack with respect to the normal is increased, and the implantation dose is decreased, from one successive implantation to another.

8. Process according to Claim 5, **characterized in that** the series of successive implantations consists in implanting the dopant of the second conductivity type using the same angle of attack with respect to the normal to the substrate, the same dose and the same implantation energy and subjecting, between each successive implantation, the device to a different anneal.

**Patentansprüche**

1. Halbleiterbauelement, das ein Halbleitersubstrat (1), das eine vorbestimmte Konzentration Ns eines Dotierungsstoffs mit einem ersten Leitfähigkeitstyp aufweist, Source- (2) und Drain-Bereiche (3), die mit einem Dotierungsstoff mit einem zweiten Leitfähigkeitstyp dotiert sind, der dem ersten entgegengesetzt ist, und in dem Substrat Übergänge (4, 5) definieren, die einen Kanalbereich (6) mit einer vorbestimmten Nennlänge LN abgrenzen, und eine erste Tasche (7, 8) aufweist, die jedem der Übergänge (4, 5) im Kanalbereich (6) benachbart ist und eine vorbestimmte Länge Lp aufweist, wobei die ersten Taschen (7, 8) mit einem Dotierungsstoff mit dem ersten Leitfähigkeitstyp mit der Konzentration Np dotiert sind, der die Nettokonzentration des Substrats lokal über Ns hinaus erhöht, wobei dieses Bauelement im Kanalbereich (6) mindestens eine zweite Tasche (9, 10) aufweist, die jedem der Übergänge (4, 5) benachbart ist und über jeder der ersten Taschen (7, 8) liegt, wobei die zweiten Taschen (9, 10) eine Länge Ln aufweisen, derart, dass Ln > Lp, und mit einem Dotierungsstoff des zweiten Leitfähigkeitstyps mit einer Konzentration Nn dotiert sind, derart, dass Nn < Np, und die Nettokonzentration des Dotierungsstoffs mit dem ersten Leitfähigkeitstyp im Substrat lokal vermindern, und die Konzentration Nn des Dotierungsstoffs mit dem zweiten Leitfähigkeitstyp der zweiten Taschen die Beziehung Nn < Ns erfüllt.

2. Halbleiterbauelement nach Anspruch 1, **dadurch gekennzeichnet, dass** die zweiten Taschen (9, 10) mehrere Elementartaschen aufweisen, die übereinander liegen, wobei jede Elementartasche eines gegebenen Rangs i eine vorbestimmte Länge $Ln_i$ und eine vorbestimmte Konzentration des Dotierungsstoffs mit dem zweiten Leitfähigkeitstyp $Nn_i$ aufweist, die die Folgenden Beziehungen erfüllen:

$$Ln_1 > Lp$$

$$Ln_{i-1} < Ln_i < Ln_{i+1}$$

$$Nn_{i-1} > Nn_i > Nn_{i+1}$$

und
wobei die Summe $\Sigma Nn_i$ der Konzentrationen des Dotierungsstoffs mit dem zweiten Leitfähigkeitstyp der mehreren Elementartaschen die Beziehung $\Sigma Nn_i < Ns$ erfüllt.

3. Bauelement nach Anspruch 1 oder 2, **dadurch gekennzeichnet, dass** das Bauelement ein MOS-Transistor ist.

4. Verfahren zum Ausführen eines Halbleiterbauelements nach Anspruch 1 oder 2, das Folgendes aufweist:

- das Bilden eines Source-Bereichs (2) und eines Drain-Bereichs (3), die mit einem Dotierungsstoff mit einem zweiten Leitfähigkeitstyp dotiert sind, der dem ersten entgegengesetzt ist, in einem Halbleitersubstrat (1), das eine vorbestimmte Konzentration Ns eines Dotierungsstoffs mit dem ersten Leitfähigkeitstyp aufweist, wobei die Source- und Drain-Bereiche in dem Substrat Übergänge (4, 5) bilden, die zwischen einander einen Kanalbereich (6) abgrenzen, der eine vorbestimmte Nennlänge L aufweist, und
- das Bilden einer ersten Tasche (7, 8), die eine vorbestimmte Länge Lp und eine vorbestimmte Konzentration Np des Dotierungsstoffs mit dem ersten Leitfähigkeitstyp aufweist, die die Nettokonzentration des Substrats lokal über Ns hinaus erhöht, im Kanalbereich (6) in einem Bereich, der jedem der Übergänge (4, 5) benachbart ist, **dadurch gekennzeichnet, dass** es ferner Folgendes aufweist:
- das Implantieren eines Dotierungsstoffs mit dem zweiten Leitfähigkeitstyp, der dem ersten entgegengesetzt ist, im Kanalbereich (6) unter den Bedingungen, die derart sind, dass sich im Kanalbereich (6) mindestens eine zweite Tasche (9, 10) bildet, die jeweils über jeder der ersten Taschen (7, 8) liegt, wobei diese zweite Tasche eine Länge Ln, derart, dass Ln > Lp, und eine Konzentration Nn des Dotierungsstoffs des ersten Typs aufweist, derart, dass Nn < Np, und die Nettokonzentration des Dotierungsstoffs mit dem ersten Leitfähigkeitstyp im Substrat lokal vermindert, und die Konzentration Nn des Dotierungsstoffs mit dem zweiten Leitfähigkeitstyp der zweiten Taschen die Beziehung Nn < Ns erfüllt.

5. Verfahren nach Anspruch 4, **dadurch gekennzeichnet, dass** die Implantation des Dotierungsstoffs mit dem zweiten Leitfähigkeitstyp aus einer Reihe von aufeinanderfolgenden Implantationen besteht, derart, dass die zweiten Taschen (9, 10) jeweils durch mehrere übereinanderliegende Elementartaschen gebildet werden, wobei jede Elementartasche eines gegebenen Rangs i eine Länge $Ln_i$ und eine Konzentration $Nn_i$ des Dotierungsstoffs mit dem zweiten Leitfähigkeitstyp aufweist, die die folgenden Beziehungen erfüllen:

$$Ln_1 < Lp$$

$$Ln_{i-1} < Ln_i < Ln_{i+1}$$

$$Nn_{i-1} > Nn_i > Nn_{i+1}$$

und
wobei die Summe $\Sigma\, Nn_i$ der Konzentrationen des Dotierungsstoffs mit dem zweiten Leitfähigkeitstyp der mehreren Elementartaschen die Beziehung $\Sigma\, Nn_i < Ns$ erfüllt.

6. Verfahren nach Anspruch 4 oder 5, **dadurch gekennzeichnet, dass** die Implantationsbedingungen den Einfallswinkel der Implantation in Bezug zur Normalen zum Substrat sowie die Implantationsdosis und -energie aufweisen.

7. Verfahren nach Anspruch 5, **dadurch gekennzeichnet, dass** in der Reihe von aufeinanderfolgenden Implantationen der Einfallswinkel in Bezug zur Normalen erhöht wird und die Implantationsdosis von einer Implantation zur darauf folgenden vermindert wird.

8. Verfahren nach Anspruch 5, **dadurch gekennzeichnet, dass** die Reihe von aufeinanderfolgenden Implantationen darin besteht, den Dotierungsstoff mit dem zweiten Leitfähigkeitstyp unter Verwendung desselben Einfallswinkels in Bezug zur Normalen zum Substrat, derselben Dosis und derselben Implantationsenergie zu implantieren und das Bauelement zwischen jeder aufeinanderfolgenden Implantation einer unterschiedlichen Glühbehandlung zu unterziehen.

# FIG.1

# FIG.2

# FIG.3

**EP 1 186 051 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 06318698 B
- US 5371394 A
- EP 0763855 A

**Littérature non-brevet citée dans la description**

- **HAJIMA KURATA ; TOSHIHIRO SUGII.** Self-Aligned Control of Threshold Voltages in Sub-0.2-$\mu$m MOSFET's. *IEEE Transactions on Electron Devices,* Octobre 1998, vol. 45 (10